# EUROPEAN PATENT SPECIFICATION

(11) **EP 1 363 336 B1**
(45) Date of publication and mention of the grant of the patent: **10.01.2007**
(21) Application number: 03253071.9
(22) Date of filing: 16.05.2003
(51) Int. Cl.: H01L 41/047, B06B 1/06, H01L 41/22

(54) **Transducer assembly**
Wandlervorrichtung
Dispositif transducteur

(30) Priority: 17.05.2002 GB 0211405
(43) Date of publication of application: 19.11.2003
(73) Proprietor: THE MORGAN CRUCIBLE COMPANY PLC, Windsor, Berkshire SL4 1LP (GB)
(72) Inventor: Bromfield, George, Salt Lake City, Utah 84124 (US); Warnham, Gordon, c/o Morgan Electro Ceramics, Southampton SO19 7TG (GB); Kennaugh, Martyn, c/o Morgan Electro Ceramics, Southampton SO19 7TG (GB)
(74) Representative: Boff, James Charles

(56) References cited:
- WO-A-97/49556
- WO-A-03/026810
- US-A- 5 798 599
- PATENT ABSTRACTS OF JAPAN vol. 2000, no. 15, 6 April 2001 (2001-04-06) -& JP 2000 350964 A (TOKIN CERAMICS CORP), 19 December 2000 (2000-12-19)

## Description

The present invention relates to high power sandwich-type ultrasonic transducers.

Sandwich-type ultrasonic transducers, also called Langevin transducers, are well known and established for the production of high intensity ultrasonic motion. GB 145,691 of 1921 discloses a sandwich of piezoelectric material positioned between metal plates to produce high intensity ultrasound. Sandwich transducers utilising a bolted stack transducer tuned to a resonant frequency and designed to the length of the half wavelength of the resonant frequency are described in GB 868,784.

High-intensity ultrasonic transducers of the composite or sandwich-type typically include front and rear mass members with alternating annular piezoelectric elements and electrodes stacked inbetween. They employ a compression bolt that extends axially through the stack to place a static bias compressive force on the piezoelectric elements, which is typically of the order of half of the maximum compressive force that the piezoelectric material can tolerate. This ensures that when the transducers operate they always remain in compression, swinging from a maximum to a minimum value of compressive stress throughout the vibration cycle. The maximum not exceeding the compression strength of the material. Typically, the bolt is screwed into the front mass member, and tensioned against the rear mass member by a nut.

Further methods of applying the pre-load are disclosed in International Patent Publication No. WO 03/026810. Here the bolt is replaced by a pultruded tube or rod of a fibre, preferably glass fibre, composite, in which the fibres are aligned along the direction of the precompression force. This is bonded or crimped in place and is advantageous as the reduced Young's Modulus of the composite, when compared to a steel bolt, results in an increased compliance in the transducer stack, and reduces torsional stresses that can lead to radial cracking and failure. However, even this improved design suffers from transmission losses during use.

Hand-held surgical instruments based on piezoelectric transducers are used in various medical and dental fields, such as phacoemulsification and liposuction. Ultrasonic instruments are advantageous because the may be used to cut, coagulate, emulsify and dissect organic tissue using energy in the form of mechanical vibrations transmitted to a surgical end effector at ultrasonic frequencies, at suitable energy levels and using suitable end effectors (for example, needles, probes or blades) attached to a horn.

Ultrasonic vibration is induced in the surgical end effector by, for example, electrically exciting a transducer which may be constructed of one or more piezoelectric elements in the instrument handpiece. Vibrations generated by the transducer section are transmitted to the effector via an ultrasonic waveguide extending from the transducer to the effector.

However, other transducer systems include flex-torsional mode assemblies and segmented cylinder assemblies. These may also operate at frequencies other than those in the ultrasonic range, for example assemblies used in sonar and welding equipment.

All transducer systems suffer from losses associated with the connections between the piezoelectric ceramic elements and the electrodes and other assembly components, for example the front and rear end masses used in sandwich-type assemblies.

In order to reduce such transmission losses between the piezoelectric material and the mass members, it is necessary to keep the surfaces of each component in intimate contact, throughout the vibration cycle. This ensures that the maximum acoustic transparency is obtained. Furthermore, the existence of voids and defects in the surfaces in contact can generate losses by reflected energy that is out of phase with the initial ultrasonic wave travelling along the waveguide.

One method of reducing such losses is to use a lapping process on all parts in contact within the stack. This involves producing a surface with low roughness (generally of the order of approximately 10nm) by polishing and lapping. The idea behind this is that by reducing the surface roughness of parts in contact, the amount of air between the parts is minimised, thus decreasing the effect of any surface voids or defects. This however increases production time and costs substantially.

A second method of reducing such losses is to form a join between adjacent parts by bonding with epoxy resin. This has the advantage of filling any surface defects and voids, producing a flat surface, and ensuring that adjacent parts are kept in intimate contact with each other, without the possibility of an air gap being formed. However, in general the use of epoxy with transducer stack systems is problematic. The heat generated and dissipated within the stack structure during operation cause the epoxy to heat up, creating a softening of the joins between adjacent parts of the stack. This can lead to increased transmission losses and ultimately to the failure of the joint. Furthermore, the epoxy itself is difficult to work with, creating problems with controlling the initial thickness of the joint.

A similar solution to using epoxy to fill the surface voids and defects, but without creating the difficulties discussed above is disclosed in US 5,798,599. Here 'crush washers' are placed between adjacent piezoelectric elements as well as the front and rear masses. On applying the static bias, the washers are crushed (as the name implies), filling surface voids and defects. Each electrode has a crush washer position on either side in this arrangement. A washer is fabricated from a conductive metal which is soft enough to allow this deformation, but hard enough to retain its shape and not flow to extent that the compression of the transducer assembly is eventually relaxed. In particular it is necessary that no coining or further deformation occurs when the compressive force is applied and the work hardening characteristics of the metal must allow continued deformation until the compression per square unit is too low to support any further change. Metals satisfying these criteria include aluminium, lead, tin, zinc and gold. These metals are annealed when necessary to 'dead soft grades', with the preferred material being aluminium. However, although the performance of the transducer stack is greatly improved, the use of such washers increases the expense of stack construction, making them unsuitable for mass produced units.

Therefore there is a need for a low-cost alternative to the crush washer, which has none of the disadvantages of lapping or employing an epoxy resin, to increase the efficiency and performance of transducer assemblies.

WO97/49556 discloses a process in which an electrode is applied to piezoelectric transducers by bonding a deformable thin film of a dielectric and electrode to the surface of the piezoelectric layer with a thin layer of adhesive material, such as epoxy resin.

Accordingly, the present invention provides a piezoelectric assembly, comprising at least one piezoelectric element and at least one electrode assembled to lie between an energy delivery member and a pre-loading member, characterised in that the electrode further comprises, where in contact with the piezoelectric element, an adherent coating of a material which is sufficiently compliant so as to deform under the pre-loading stress and conform to the surface of the piezoelectric element.

Subsidiary features of the invention are set out in the claims and also discussed below.

The invention is illustrated by, although not limited to, the following example and drawings in which:
Figure 1 is a schematic illustration of suitable electroplating apparatus for use with the invention.
Figure 2 is an illustration of a hand held surgical device comprising electrodes in accordance with the present invention.

Any convenient electrode material may be used, for example beryllium-copper, nickel, stainless steel, Monel^{™} (Ni₆₅-Cu₃₃-Fe₂ alloy), nickel/iron alloy, brass and phosphor-bronze. Preferably, the electrode is a Be-Cu foil, as shown in the example below.

The coating may be provided by any suitable known method, although the inventors have found electroplating to be particularly advantageous. This allows a low cost and easily controllable coating to be applied to the electrode surface.

Aside from the obvious advantages of electro (or electroless) plating, in that there are a wide range of metal finishes which can be applied, it is a low temperature process, i.e. it can be applied at temperatures below 100°C (the limitation of aqueous systems).

There is a wide range of metal/metal and metal/non-metal alloys (such as cobalt/gold, tin/lead, nickel/boron, for example) which can be applied using the same techniques. Thus it is possible to take advantage of the alloy's properties to suit the application required (cobalt/gold has the electrical properties of gold but with added wear resistance). The ratio of these alloyed coatings may also be altered to suit the application required (e.g. 60/40; 70/30; 90/10 tin/lead coatings used for melting point, ductility or their electrical properties). It is also possible to electroplate aluminium, but only in very expensive plants.

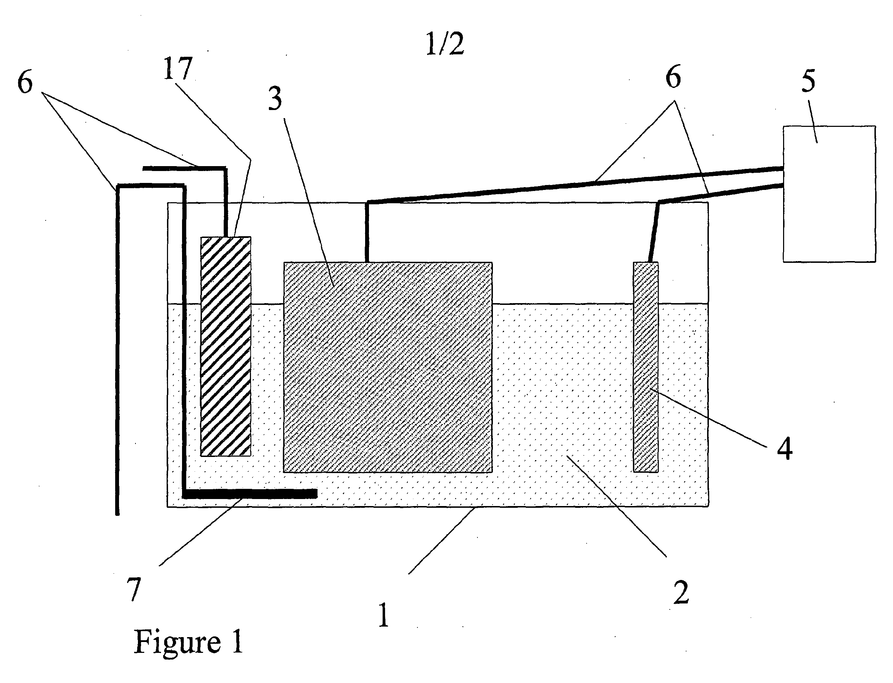

An electroplating bath, suitable for use with the invention is schematically illustrated in Figure 1. A tank 1, of a suitable construction to withstand both raised temperature and chemical attack, is filled with a plating chemical solution 2, typically comprising: de-ionised water to enable the dissolution of the chemicals allowing ion formation to conduct electricity and carry the metal ions to form an electrodeposit, metal salts which are the direct (or indirect) source of the metal deposited (the salt is formed from an acid and a base and may be organic or inorganic, simple or complex) and other additives such as pH regulators/buffers, brightening, wetting or levelling agents. The cathode workpiece 3 and anode 4 are connected to a rectifier 5 by various electrical connections 6 (shown as thick black lines). A pump/filler unit 17, to filter the solution 2 constantly and provide sufficient agitation, and a heater 7, to maintain the required temperature are also provided. The set-up also includes a thermistor for temperature control and a stirrer to provide further agitation (not shown).

The driving force for the electrodeposition (reduction) is either by a chemical reducing agent (in the case of electroless systems) or by an applied current. The electro-deposition of a metal can be considered an electrode, electrochemical, charge transfer or Faradaic reaction. The chemical reduction reaction taking place at each electrode, in the case of Cu, is shown below:

Cathode: Cu²⁺ + 2e ^{-----→} Cu₍ₘₑₜₐₗ₎ Deposition

Anode: Cu₍ₘₑₜₐₗ₎ ^{------→} Cu²⁺ + 2e⁻ Dissolution

There are three main stages in plating out a metal:
1. Bringing the ions to the cathode surface (diffusing under a concentration gradient)
2. The Faradaic reaction (in which ions are converted to metal atoms)
3. The ordering of the deposited metal atoms into a structured metal lattice. This is the rate determining step.

There are various parameters significant in achieving effective electro (electroless) plating.

### Agitation

Optimum agitation creates the uniform distribution of metal ions in the bulk of the solution, preventing build up of species around the anode and depletion around the cathode. This will also decrease the diffusion layer making it easier for metal ions to diffuse to the cathode.

### Temperature

Optimum temperature ensures deposition at constant rate and allows metal salts to fully dissolve (i.e. raising the solubility constant).

### pH

This must be controlled carefully in order to optimise electrode efficiency and is dependent on bath system type. No plating system is 100% efficient, usually some hydrogen is formed at the cathode (and oxygen can be formed at the anode).

### Current density

The maximum current density employed is usually dependant on a number of other the other factors (above), however if too high a current density is used, deposition is not in a regular matrix, and the resulting deposit will look 'burnt'

### Solution maintenance

Regular analysis is necessary to ensure a constant supply of metal ions available for plating and that operating parameters of the solution are optimised

### Specific gravity (SG)

Measuring the specific gravity is a quick and easy way of assessing whether all of the components are at optimum levels in the bath.

The plating process used to make electrodes for a test transducer is as follows:
Stage 1: Degrease the electrode material.
Stage 2: Clean the electrode in a hot soak cleaning solution, then rinse.
Stage 3: Dip the electrode in a hydrochloric acid dip, then rinse.
Stage 4: Descale the electrode using a phosphoric acid descaler, then rinse.
Stage 5: Immerse the electrode in a chromic acid dip, then rinse.
Stage 6: Immerse the electrode in a bright acid dip, then rinse.
Stage 6: Clean the electrode using a cold cleaning solution, then rinse.
Stage 7: Electroplate copper undercoat, then rinse.
Stage 8: Dragout and clean rinse.
Stage 9: Electroplate compliant coating layer.
Stage 10: Dragout and clean rinse.
Stage 11: Rinse in sodium hydroxide, then rinse.
Stage 12: Dry coated electrode.

Pre-treatments may also be used, including immersion in acid pickles (pre-clean) to remove tarnish and oxidation. Electroplating of an undercoat usually takes place in a sulphuric acid based electrolytic copper plating system at 0.47-0.93 A/m² (5 - 10 Amps per ft²) for a time given to achieve an intermediate coating of ~0.5µm of copper for adhesion/leach resistance purposes. The undercoat acts as a buffer layer, improving the adhesion of materials with a different crystal structure to that of the electrode. Electroplating of the final coat usually takes place in a fluoborate based electrolytic 60/40 tin/lead plating system at 0.47-0.93 A/m² (5 - 10 Amps per ft²) for a time given to achieve a final coating thickness of ~10 µm. The electrodes are then air or oven dried, as appropriate.

Ideally the coating of compliant material is soft enough to deform into the roughness of the piezoelectric material under the pre-loading stress, whilst hard enough to retain its overall shape and not flow between the elements under increasing compressive stress. Furthermore, the thermal expansion coefficient of the material chosen should be similar to that of the electrode, so as to reduce any problems caused by the heating of the transducer stack during operation. The coating of compliant material should also display work hardening characteristics suitable for a system undergoing such an extreme compressive stress cycle. The minimum thickness of the coating is dictated by the surface roughness of the piezoelectric ceramic. The absolute minimum coating thickness should be enough to fill the surface defects of the piezoelectric ceramic material such that the uppermost part of the rough surface is in contact with the electrode material. The maximum coating thickness is dictated by the point in which the electric losses within the coating layer (for example those due to heating or skin depth) negate the beneficial effect of closing any surface defects or porosity. The inventors have found that the coating should have a thickness of between 5 and 30µm, allowing the effects of any surface defects in the piezoelectric ceramic to be minimised and producing negligible losses due to the coating material itself.

Suitable coating materials are 60/40 tin/lead (bright or satin finish) 70/30 tin/lead (bright or satin finish), 90/10 tin/lead (bright or satin finish), tin (matt or bright finish), lead, silver, copper and gold.

Further methods of providing a suitable compliant coating include:
Electrostatic Powder coating
   Metallic powder is applied using an electrostatic spray gun and because of this we can coat the substrate as thick as we like on an object of any size or shape. The object is then stoved and the powder melts and flows to give an even uniform coating. It is fair to say that the limitation is the size of the stoving oven.
Flame (metal) spraying
   The metal is supplied in finely divided powder form or as a wire and passed with compressed gas, through a flame (such as an oxy-acetylene flame) or electric arc. These melt the metal, which in the blast of compressed gas, is converted to a spray of molten metal. Because the surrounding area is also hot, the sprayed metal remains molten until it hits the surface of the substrate, which is thus coated.
Vacuum evaporation
   This consists of a high vacuum chamber, which contains a lump (or wire) of the chosen metal to evaporate. There will be a means of heating the metal (usually with an electric filament), by passing electricity through it and it vaporises and spreads out in all directions. This coats everything in the chamber including the object we wish to coat.
Sputtering
   Sputtering techniques, such as cathodic and magnetron sputtering use similar methodology to vacuum evaporation above, except a high voltage is placed between the source metal and that which we wish to coat. Instead of a vacuum, an inert gas is used at low pressure. Under the applied voltage the gas is ionised. The ions bombard a target or source made of the metal, causing it to vaporise. The metal ions then migrate under the voltage gradient and then deposit onto the object requiring coating.
Roll coating
   Here we lay a thin sheet of metal on top of a sheet of our substrate metal and then pass it through a pair of rollers. They emerge bonded together.

Yet further possible methods include explosive bonding, ion plating and ion implantation.

The invention is particularly suited to producing a number of coated electrodes by stamping from an electroplated sheet. This is advantageous not only from the aspect of commercialising the invention and mass-producing electrodes at low cost, but gives an additional benefit in reducing dielectric losses further. If an individual electrode is plated, the resulting coating varies in thickness at the periphery of the electrode, due to the meniscus formed when the electrode is removed from the plating bath. This can add to the dielectric losses of the assembled transducer system. Stamping electrodes out of a coated sheet results in electrodes with a flat coating across their entire surface, and reduces dielectric losses in the transducer assembly further.

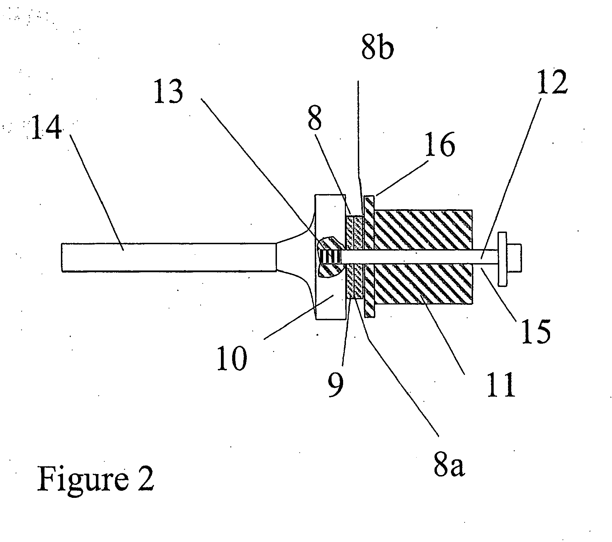

The surgical instrument may be assembled as illustrated in Figure 2. Electrodes 8, comprising a coating of 60/40 Sn-Pb (bright or satin finish) on both sides of a Be-Cu foil are placed between the pair of piezoelectric ceramic elements 9 and the rear mass 11, with wires for electrical connection 8a and 8b attached to each electrode. The elements are of US Navy Type-I or Type-III piezoelectric material. The elements are sandwiched between a front mass 10 and the rear mass 11, forming the transducer stack. A bolt 12 secures the stack, and applies the pre-load compressive force via sleeve 15 engaging load plate 16 but running freely in rear mass 11, the bolt" being engaged with the front mass at screw thread joint 13. A transducer horn 14 is provided, onto which an end effector, for example a needle, probe or blade, (not shown) is fitted. This end effector vibrates when the transducer stack is driven near the resonant frequency, with the maximum displacement of the end effector tip occurring at resonant frequency. A cover (again, not shown) comprising a hollow tube or housing, may be fitted over the stack and secured either at the front mass or by the use of an additional washer at the head end of the bolt. A pultruded tube may also be used to provide the pre-load, as described in PCT Patent Publication No. WO 03/026810.

In order to assess the improvement performance enabled by the present invention, the inventors performed a comparison test between a standard transducer and a transducer made in accordance with the present invention.

Two test transducers were constructed, a control transducer comprising Be-Cu foil electrodes and an exemplary transducer, comprising Be-Cu foil electrodes coated with a 10µm thick Sn-Pb coating on each side. The pre-load was applied using a high tensile cap headed screw. In order to seat the unplated Be-Cu electrode into the Ag-coating on the surface of the pieozoelectric ceramic ring it was necessary to apply an initial pre-load of 80 MPa. The load was then decreased to approximately 35 MPa, which is a typical value for such an assembly. Table 1 below details the changes between using the control transducer and using an exemplary transducer. Both transducers were operated at 55 kHz. A typical impedance value for the control transducer is approximately 30 Ω.

| | | | |
|---|---|---|---|
| Resonant Frequency | Impedance at resonance | Coupling coefficient | Q factor |
| +2.9% | -22% | +2.3% | +13% |

This shows a substantial decrease in impedance losses, coupled with an increase in Q factor, resonant frequency and coupling co-efficient.

A reduction in losses indicates in increase in the efficiency of the heat dissipation. This is particularly important in systems where the transducer is operated in continuous duty cycles in the no-load condition, for example, in welding, due to that fact that the piezoelectric ceramic used has a very high Q value, and therefore requires a number of cycles (equal to the value of Q) to reach approximately 97% of its resonant frequency.

An important further aspect of the invention is now described.

**Etching of PZT Ceramic to facilitate mechanical bonding to plated Beryllium copper shim under determined conditions for use in medical application, sonar transducers, and other high power ultrasonic transducers**

### Purpose

To further reduce the acoustic loses associated with the joint between the piezo elements of Langevin type high power transducer assemblies. The description above is based on a method using plated shims. We have further found that optimum performance can be achieved by etching the surface of the mating faces of the piezo elements.

### Basic Principle

A mechanical bond is formed by having a suitably etched PZT ceramic surface, which is then mated to a tin/lead plated beryllium/copper shim, or other electrode as above, by applying pressure (via torque applied to bias bolt) and temperature. This allows the tin/lead (solder) or other compliant coating alloy to flow into the crevices formed by etching and joins with the subsequent alloy deposit and, on cooling, produces a strong interlocked mechanical bond. Tensile testing of this bonding method has resulted in fracture stresses that exceed those specified by US Department of Defence for silver adhesion to the face of a piezo element. The specification for a pull test for a soldered wire with a solder blob 3mm diameter equates to a joint stress of 5 MPa. Tensile tests of joints using our new method have typically failed between 5 MPa and 7MPa. The good mechanical bond results in lower electrical losses within the joint. For example, when operated at resonance frequency, prior art transducer stack assemblies had a typical average minimum impedance of 15Ω whereas similar stack assemblies using the new method have an average value of impedance of 10Ω.

The bond strength is dependant upon a number of factors. The etching method, the thickness and composition of shim plated alloy, assembly pre-load cycle, temperature cycle, and application of ultrasonic energy. Optimum joint strength was achieved by lapping the surface of the piezo element after poling and thereby removing the electrically conductive coating. The piezo element is then etched using the process described below. The optimum shim is fabricated from approximately 76µm [0.003"] thick sheet beryllium copper that is electroplated with 5µm thick 90% tin 10% lead. The components are assembled in the stack assembly that is then subjected to a measured compressive force. A force corresponding with a ceramic pre-stress of 60 MPa is applied, maintained for approximately 10 minutes, and subsequently reduced to between 30 to 35 MPa. This level will correspond with the functional level that will need to be re-applied to the stack assembly. A capacitor attenuation test fixture is connected to the stack assembly and the voltage is measured as the load is reduced to zero. The stack assembly is then removed from the test fixture, the centre bolt is inserted, reconnected to the capacitor attenuation fixture, and the bolt subsequently tightened to a voltage level corresponding with that measured during the removal of the pre-load.

The stack assembly is then placed in an oven at a temperature of 140°C for a minimum period of 12 hours (overnight for our tests). After cooling for at least 2 hours at room temperature the stack assembly is tested at maximum power corresponding with a specified level of end effector displacement. This level of power is maintained for a period of approximately 10 minutes to allow the temperature within the stack to stabilise (typically 60°C). The assembly is then stored at room temperature and re-tested after a period of 24 hours.

The above assembly method was developed for re-usable medical transducers that will need to be sterilised using the steam autoclave method, hence the 140°C temperature cycle. We have attempted to validate the method and try and determine critical times, pressures, temperatures, and test conditions. The application of 140°C temperature cycle is an important aspect of the assembly method described.

During high power testing of assemblies using this method it was noticed that the measured electrical impedance at the resonance frequency remained remarkably stable with increasing levels of power. This has the potential to significantly improve the power handling capability of transducer stack assemblies compared with prior art assemblies using epoxy. At high temperatures the epoxy softens, the acoustic loss increases, the electrical impedance increases, and this can result in excessive heat generation and permanent damage/total destruction of the stack assembly.

### Surface characteristics of the ceramic

In order to create the 'mechanical' bond described above, it is necessary to 'key' the surface of the ceramic. In order to achieve the necessary 'roughness' of the ceramic, micro etching is carried out. This is facilitated by immersing the components in a dilute solution (pickle) of acids. The acids used in the etching bath specifically target the grain boundaries of the PZT ceramic causing the effect shown below. The 'pickle' below consists of a mix of HF and HCl, but etchants used on ceramic are not limited to these chemicals, eg, other fluoride based systems may be used as can phosphoric acid, nitric acid, hydrogen peroxide and potassium chromate containing dips.

Ideally the ceramic surface will be evenly etched, without damage to the grain faces and have an open structure to allow interlocking of the solder alloy on the surface.

If over etching-occurs, the interlocking bond will not form with the same mechanical strength.

### Parameters

The parameters for etching the surface to create the required mechanical bond may vary with ceramic composition. These parameters and their effect on etching rate are listed below:
◆ The solvent degreasing sequence
   The purpose of the degreasing sequence is to remove any grease / oil from the ceramic surface left by the pre-production stages. Without this, 'wetting' the ceramic surface with aqueous chemicals will be difficult, as soils, fingerprints and other materials can remain on the surface and cause non-uniform etching or removal of debris.
◆ The aqueous degreasing sequence
   As for the solvent degreasing stage, however this is also designed to ensure that the components 'wet' prior to entering the acid etch sequence by removing particles and ceramic dust in the pores. The temperature of the solution is important as at critical temperature the solution reaches its cloud point. This is the temperature, which it is most effective at dissolving the contaminants.
◆ Time in acid etch
   The amount that the surface is etched will increase with increasing immersion time in the etch solution.
◆ Temperature of acid etch
   The amount that the surface is etched will increase with increasing temperature of the etch solution (raising the temperature will speed up the reaction).
   Optimum temperature means etching at constant rate and allows the acids to fully dissociate.
◆ Concentration of acid etch
   The amount that the surface is etched will increase with increasing acid concentration of the etch solution.
◆ Agitation of acid etch
   Whilst in the etching solution, the parts should be moved constantly in order to ensure that all surfaces of the components on the jig are etched.
◆ Tap water rinsing
   The rinsing stage removes the acid from the surface of the components so that over etching does not occur, also it prevents the other tanks from becoming polluted.
◆ Time in U/S rinse
   As discussed above, the acid-etch attacks/dissolves the ceramic around the grain boundaries but leaves it present and somewhat loose within the surface structure. The U/S (ultrasonic) rinse is important as it removes the ceramic debris from within the surface structure of the components, leaving an open structure, which can be mechanically bonded to. If the ceramic debris is not removed it will be trapped between the solder coating and the ceramic substrate and is likely to affect the di-electric constant of the PZT component by causing an increase in resistance and dielectric losses.

### Typical etching sequence

1. Degrease in lab solvent degreaser. Vapour for 3mins, then U/S for 3mins.
2. Immerse in 2% Triton X100 Soap cleaner at 60°C for 3 mins, then rinse thoroughly to remove soap.
3. Tap water swill and 30 seconds in clean de-mineralised water in ultrasonic tank to remove residual debris.
4. 3x Hydrochloric acid (5 vol%): Hydrofluoric acid (0.5 vol%) acid etch cycle
5. Immerse in 2% Triton X100 Soap cleaner at 60°C for 3 mins, then rinse thoroughly to remove soap.
6. Dry thoroughly using 'dry' compressed airline
7. Vacuum dry at 1bar vacuum, 200°C to remove excess moisture.

### Acid Etch cycle

1. 1 minutes etch with gentle agitation & rinse.
2. 1 minute clean in ultrasonic tank - residue/debris should be seen to come from the ceramic. Move jig around in tank until all residue/debris removed.
3. 1 minutes etch with gentle agitation & rinse.
4. 1 minute clean in ultrasonic tank - Move jig around in tank until all residue/debris removed.
5. 1 minutes etch with gentle agitation & rinse.
6. 1 minute clean in ultrasonic tank - Move jig around in tank until all residue/debris removed.
7. Tap water swill thoroughly to dilute any residual acid and remove surface debris

### Examples

The following are examples of timing and other specifics

| Time in vapour degrease | Optimal | Minimum | Maximum |
|---|---|---|---|
| (solvent eg triklone) | 3 mins | 1 second | 10 mins |

| Time in U/S degrease | Optimal | Minimum | Maximum |
|---|---|---|---|
| (solvent eg triklone) | 3 mins | 1 second | 10 mins |

| Time in U/S degrease | Optimal | Minimum | Maximum |
|---|---|---|---|
| (aqueous soap) | 5 mins | 1 second | 10 mins |

| Time in acid etch | Optimal | Minimum | Maximum |
|---|---|---|---|
| | 3 mins | 1 second | 10 mins |

| Temperature of acid etch | Optimal | Minimum | Maximum |
|---|---|---|---|
| | 20 °C | 0 °C | 100°C |

| Concentration of acid etch | Optimal |
|---|---|
| 1. Hydrochloric acid | 5 % |
| 2. Hydrofluoric acid | 0.5% |
| 3. Water | 94.5% |

| Time in tap water rinse | Optimal | Minimum | Maximum |
|---|---|---|---|
| | 1 min | 1 second | 10 mins |

| Time in U/S rinse | Optimal | Minimum | Maximum |
|---|---|---|---|
| | 5 mins | 1 second | 10 mins |

| Time in Vac oven | Optimal | Minimum | Maximum |
|---|---|---|---|
| | 2 hours | 10 mins | 24 hours |

| Temp of Vac oven | Optimal | Minimum | Maximum |
|---|---|---|---|
| | 200 °C | Room temp | 300 °C |

| Pressure of Vac oven | Optimal | Minimum | Maximum |
|---|---|---|---|
| | 1 bar | 1 mbar | Not determined |

### Etching bath equipment

An etching tank may typically consist of the following components:
- **Tank:** Of construction to withstand both temperature and chemical attack.
- **Pump/filter:**To filter solution constantly and provide sufficient agitation.
- **Stirrer:** To provide agitation.
- **Heater unit:** To maintain required temperature.
- **Thermistor:** To control constant temperature.
- **Ultrasonic tank:** To ultrasonically clean the parts between etching stages.

### Etching chemicals

- **De-ionised water:** To dissolve the chemicals to allow the acids to dissociate.
- **Hydrochloric acid:** Etchant
- **Hydrofluoric acid:** Etchant

## Claims

1. A piezoelectric assembly for use in high power sandwich-type ultrasonic transducers, comprising at least one piezoelectric element (9) and at least one electrode (8) assembled to lie between an energy delivery member (14) and a pre-loading member (14), **characterised in that** the electrode further comprises, where in contact with the piezoelectric element, an adherent coating of a material which is sufficiently compliant so as to deform under the pre-loading stress and conform to the surface of the piezoelectric element.

2. A piezoelectric assembly as claimed in Claim 1 in which the coating has a thickness in the range 5 to 30µm.

3. A piezoelectric assembly as claimed in Claims 1 or 2 in which the coating is an electro or electroless plated coating.

4. A piezoelectric assembly as claimed in any of Claims 1 to 3 in which the electrode material is one of beryllium-copper, nickel, stainless steel, Ni₆₅-Cu₃₃-Fe₂ alloy, nickel/iron alloy, brass or phosphor-bronze.

5. A piezoelectric assembly as claimed in any of Claims 1 to 4 in which the coating is formed of one of 60/40 tin/lead (bright or satin finish) 70/30 tin/lead (bright or satin finish), 90/10 tin/lead (bright or satin finish), tin (matt or bright finish), lead, silver, copper or gold.

6. A piezoelectric assembly as claimed in Claim 4 in which the electrode is beryllium-copper.

7. A piezoelectric assembly as claimed in Claim 6 in which the coating is 60/40 tin lead.

8. A piezoelectric assembly as claimed in any preceding claim in which the electrode is a stamping from an electroplated sheet.

9. A method of making a piezoelectric assembly as claimed in any preceding claim in which the surface of the piezoelectric element is etched to provide a key for the compliant coating.

10. A method as claimed in claim 9 in which the etching dissolves material around the grain boundaries and is followed by ultrasonic cleaning to remove ceramic debris and leave an open structure.

11. A method as claimed in claim 9 or 10, in which the piezoelectric element and electrode are united by heat and pressure, with flow of the material of the coating.

## Patentansprüche

1. Piezoelektrische Anordnung zur Benutzung in leistungsstarken sandwichartigen Ultraschallwandlern, die wenigstens ein piezoelektrisches Element (9) und wenigstens eine Elektrode (8) umfasst, die zusammengesetzt sind, um zwischen einem Energielieferungsglied (14) und einem vorladenden Glied (16) zu liegen, **dadurch gekennzeichnet, dass** die Elektrode weiterhin dort, wo sie mit dem piezoelektrischen Element in Kontakt ist, eine anhaftende Beschichtung eines Materials umfasst, das ausreichend nachgiebig ist, um sich unter der vorladenden Beanspruchung zu verformen und sich der Oberfläche des piezoelektrischen Elements anzupassen.

2. Piezoelektrische Anordnung nach Anspruch 1, in der die Beschichtung eine Dicke in dem Bereich von 5 bis 30 µm hat.

3. Piezoelektrische Anordnung nach Anspruch 1 oder 2, in der die Beschichtung eine galvanisierte oder stromlos beschichtete Beschichtung ist.

4. Piezoelektrische Anordnung nach einem der Ansprüche 1 bis 3, in der das Elektrodenmaterial eins von Berylliumkupfer, Nickel, Edelstahl, Ni₆₅-Cu₃₃-Fe₂-Legierung, Nickel/Eisenlegierung, Messing oder Phosphorbronze ist.

5. Piezoelektrische Anordnung nach einem der Ansprüche 1 bis 4, in der die Beschichtung von eimem von 60/40 Zinn/Blei (Glanz- oder Satinfinish), 70/30 Zinn/Blei (Glanz- oder Satinfinish), 90/10 Zinn/Blei (Glanz- oder Satinfinish), Zinn (Matt- oder Satinfinish), Blei, Silber, Kupfer oder Gold gebildet ist.

6. Piezoelektrische Anordnung nach Anspruch 4, in der die Elektrode Berylliumkupfer ist.

7. Piezoelektrische Anordnung nach Anspruch 6, in der die Beschichtung 60/40 Zinnblei ist.

8. Piezoelektrische Anordnung nach einem der vorhergehenden Ansprüche, in der die Elektrode eine Prägung von einem galvanisierten Blech ist.

9. Verfahren zur Herstellung einer piezoelektrischen Anordnung nach einem der vorhergehenden Ansprüche, in dem die Oberfläche des piezoelektrischen Elements angeätzt ist, um eine Passform für die nachgiebige Beschichtung zu liefern.

10. Verfahren nach Anspruch 9, in dem die Anätzung Material um die Korngrenzen auflöst und von Ultraschallreinigung gefolgt wird, um keramische Ablagerungen zu entfernen und eine offene Struktur zurückzulassen.

11. Verfahren nach Anspruch 9 oder 10, in dem das piezoelektrische Element und die Elektrode durch Hitze und Druck mit Strömung des Materials der Beschichtung vereinigt sind.

## Revendications

1. Ensemble piézoélectrique, comprenant au moins un élément piézoélectrique et au moins une électrode assemblée pour reposer entre un élément de libération d'énergie et un élément de préchargement, **caractérisé en ce que** l'électrode comprend en outre, aux endroits où elle vient en contact avec l'élément piézoélectrique, un revêtement adhésif d'un matériau qui est suffisamment souple pour se déformer sous la contrainte de préchargement et à se conformer à la surface de l'élément piézoélectrique.

2. Ensemble piézoélectrique selon la revendication 1, dans lequel le revêtement a une épaisseur comprise entre 5 et 30 µm.

3. Ensemble piézoélectrique selon l'une des revendications 1 ou 2, dans lequel le revêtement est réalisé par dépôt avec ou sans courant.

4. Ensemble piézoélectrique selon l'une quelconque des revendications 1 à 3, dans lequel le matériau de l'électrode est l'un des matériaux suivant : béryllium-cuivre, nickel, acier inoxydable, Monel^{™} (un alliage Ni₆₅-Cu₃₃-Fe₂), alliage nicke l/fer, laiton ou phosphore - bronze.

5. Ensemble piézoélectrique selon l'une quelconque des revendications 1 à 4, dans lequel le revêtement est formé d'un élément parmi l'étain/plomb à 60/40 (fini brillant ou satiné), l'étain/plomb à 70 -30 (fini brillant o u satiné), l'étain/plomb à 90/10 (fini brillant ou satiné), l'étain (fini mat ou brillant), le plomb, l'argent, cuivre ou de l'or.

6. Ensemble piézoélectrique selon la revendication 4, dans lequel l'électrode est constituée de béryllium - cuivre.

7. Ensemble piézoélectrique selon la revendication 6, dans lequel le revêtement est constitué d'étain - plomb à 60/40.

8. Ensemble piézoélectrique selon l'une quelconque des revendications précédentes, dans lequel l'électrode est découpée à partir d'une feuille ayant subi une galvanoplastie.

9. Ensemble piézoélectrique selon l'une quelconque des revendications précédentes, dans lequel la surface de l'élément piézoélectrique a été gravée pour former une couche d'accrochage pour le revêtement souple.

10. Ensemble piézoélectrique selon la revendication 9, dans lequel la surface de l'élément piézoélectrique a été spécifiquement gravée pour dissoudre le matériau autour des joints de grains, la gravure étant suivie par un nettoyage aux ultrasons pour éliminer les déb ris de céramique et laisser une structure ouverte.

11. Ensemble piézoélectrique selon l'une des revendications 9 ou 10, dans lequel l'élément piézoélectrique et l'électrode ont été réunis par chauffage et pression, avec un écoulement de matériau du revêtement.
